# EUROPEAN PATENT APPLICATION

(11) **EP 2 187 465 A1**
(43) Date of publication of application: **19.05.2010**
(21) Application number: 09175870.6
(22) Date of filing: 12.11.2009
(51) Int. Cl.: H01M 2/20, H01M 10/48, H01M 2/04, H01M 2/10, G01R 31/36

(54) **Secondary battery pack**

(30) Priority: 17.11.2008 JP 2008293804
(71) Applicant: Kabushiki Kaisha Toshiba, Tokyo 105-8001 (JP)
(72) Inventor: Kosugi, Shinichiro, Tokyo 105-8001 (JP); Mizutani, Mami, Tokyo 105-8001 (JP); Ito, Yasuyuki, Tokyo 105-8001 (JP); Miyamoto, Yasuhiro, Tokyo 105-8001 (JP); Shibuya, Nobuo, Tokyo 105-8001 (JP)
(74) Representative: Schlauch, Michael

(57) **Abstract**

A secondary battery pack includes a plurality of cells (20) each including a positive electrode terminal (21) and a negative electrode terminal (22) and arranged side by side, a battery management circuit board (14) configured to monitor a voltage and temperature of the cells, and a plurality of bus-bars (18) which electrically connect the electrode terminals of the adjacent cells. The bus-bars individually includes connecting pieces (36) formed of the same material as the bus-bars, and the connecting pieces are connected directly to the battery management circuit board.

## Description

The present invention relates to a secondary battery pack with a plurality of cells and a board for battery management.

In general, a secondary battery pack is constructed so that a plurality of secondary batteries, e.g., square secondary batteries, are contained side by side in a housing. In each secondary battery, positive and negative electrode terminals are arranged flush with and spaced apart from each other. In the secondary battery pack of this type, the respective charging voltages of the individual secondary batteries (cells) need to be detected and managed.

In a secondary battery pack disclosed in Jpn. Pat. Appln. KOKAI Publication No. 2006-139919, for example, a positive electrode terminal of one of secondary batteries, e.g., two adjacent batteries, in a housing and a negative electrode terminal of the other battery are connected by a bus-bar. One end of a lead wire is connected to this bus-bar, and the other end is led around and connected to a detection circuit or the like located in a predetermined position on the housing.

According to the secondary battery pack constructed in this manner, however, led-around portions of a plurality of lead wires to be confined to a given space first need to be bundled and trued up. Secondly, the lead wires need to be connected to bus-bars and the detection circuit, so that the connection operation is complicated, and wrong connection may be caused. Thirdly, if the lead wires are increased in number with the increase of the number of secondary batteries to be accommodated, a sufficient space is expected to be secured for the positive and negative electrode terminals of the batteries to avoid wire breakage by bending, so that the housing is inevitably enlarged.

The present invention has been made in consideration of these circumstances, and its object is to provide a secondary battery pack configured so that operations for connecting secondary batteries and detection and control systems are simplified to prevent wrong connection and improve safety.

According to an aspect of the invention, there is provided a secondary battery pack characterized by comprising a plurality of cells each comprising a positive electrode terminal and a negative electrode terminal and arranged side by side; a battery management circuit board configured to monitor a voltage of the cells; and a plurality of bus-bars electrically connecting the electrode terminals of the adjacent cells, each of the bus-bars including first connecting portions connected to the electrode terminals and a second connecting portion connected directly to the battery management circuit board.

The invention can be more fully understood from the following detailed description when taken in conjunction with the accompanying drawings, in which:
FIG. 1 is a perspective view showing a secondary battery pack according to a first embodiment of the invention;
FIG. 2 is an enlarged perspective view showing a junction between a board and a connecting piece of the secondary battery pack;
FIG. 3 is an exploded perspective view of the secondary battery pack;
FIG. 4 is an exploded perspective view of the battery pack;
FIG. 5 is a sectional view of the battery pack taken along line V-V of FIG. 1;
FIG. 6 is a perspective view showing a secondary battery pack according to a second embodiment of the invention;
FIG. 7 is an exploded perspective view of the secondary battery pack according to the second embodiment;
FIG. 8 is an enlarged exploded perspective view showing a junction between a board and a connecting piece of the battery pack of the second embodiment;
FIG. 9 is a plan view showing the junction; and
FIG. 10 is an enlarged exploded perspective view showing a junction between a board and a connecting piece of a secondary battery pack according to a third embodiment.

Secondary battery packs according to embodiments of the present invention will now be described in detail with reference to the accompanying drawings.

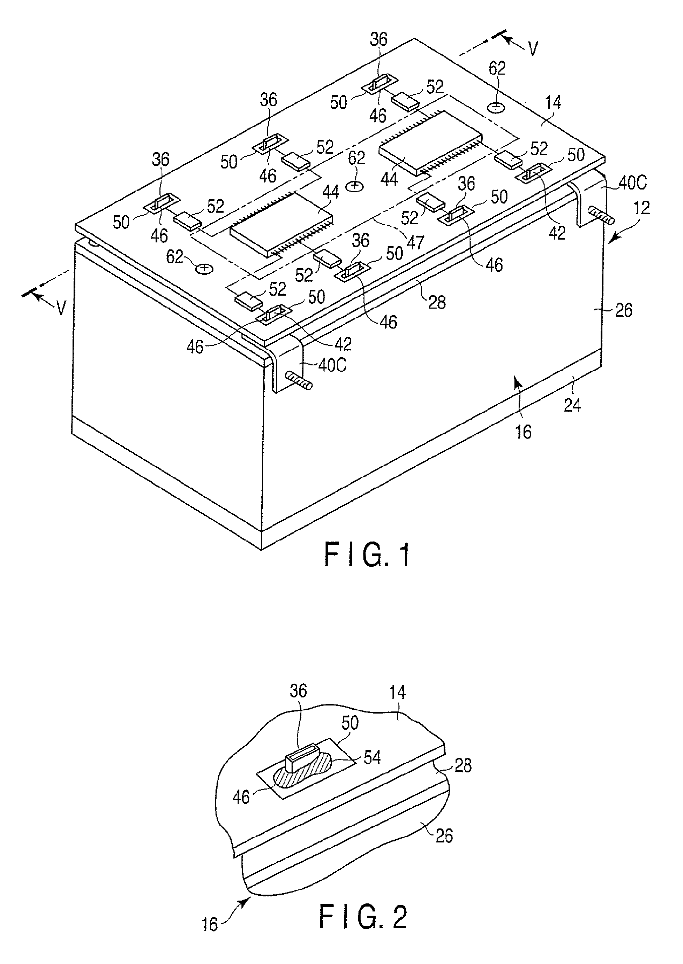

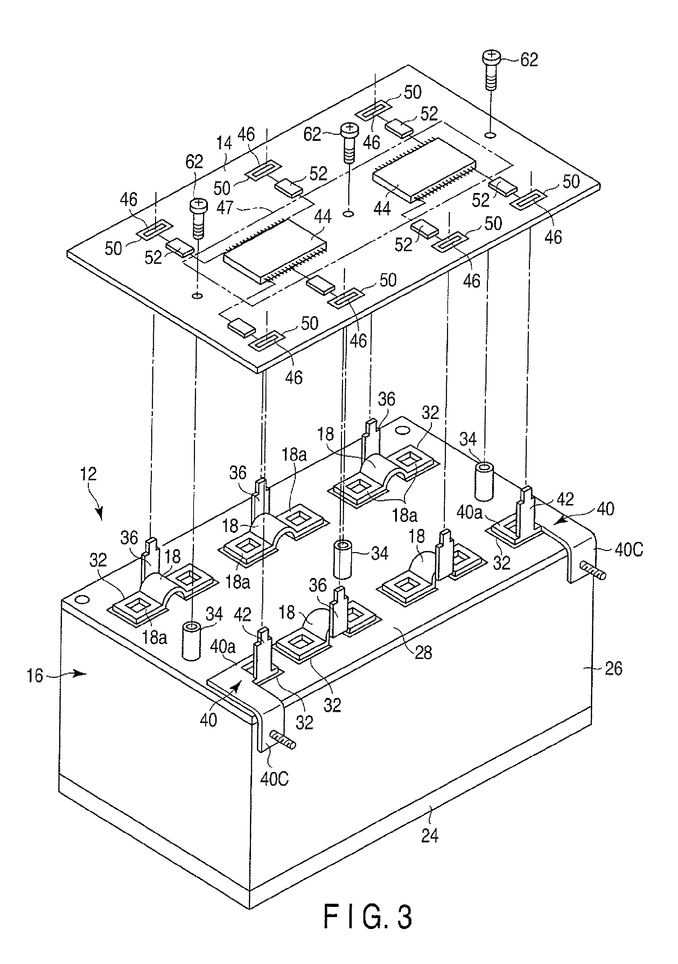

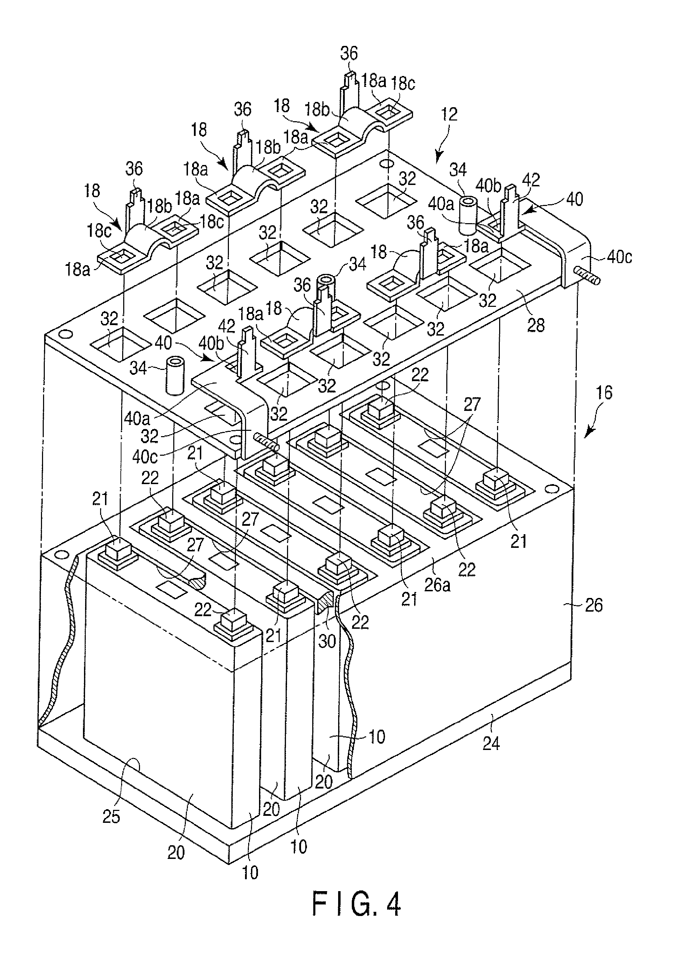

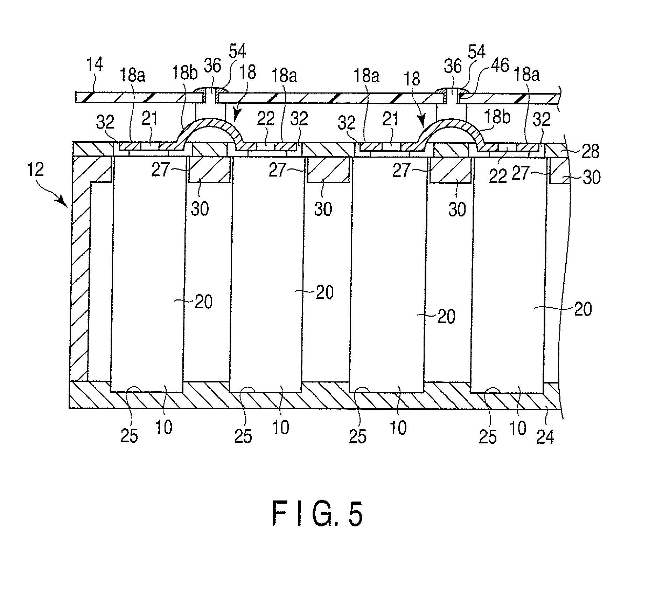

FIG. 1 is a perspective view showing an outline of a secondary battery pack according to a first embodiment, FIG. 2 is an enlarged perspective view showing a junction between a board and a connecting piece of the battery pack, and FIG. 3 is an exploded perspective view showing a body and the board of the battery pack. FIG. 4 is an exploded perspective view of the battery pack body, and FIG. 5 is a sectional view of the battery pack taken along line V-V of FIG. 1.

As shown in FIGS. 1 and 3 to 5, the secondary battery pack comprises a battery pack body 12 and a battery management circuit board 14. The battery pack body 12 comprises a plurality of (e.g., six) secondary batteries (cells) 10, a housing 16 in the form of a rectangular box for accommodating the six secondary batteries 10, and bus-bars 18 that electrically connect electrode terminals of the adjacent batteries. The circuit board 14 is connected to the batteries 10 and monitors the voltage and temperature of each battery.

As shown in FIGS. 4 and 5, each secondary battery 10 is a non-aqueous electrolyte secondary battery, such as a lithium-ion battery. For example, each battery 10 comprises a flat rectangular box-shaped container 20 formed of aluminum or aluminum alloy, an electrode body and an electrolyte (not shown) contained in the container, and positive and negative electrode terminals 21 and 22 each having, for example, a stepped rectangular shape. The electrode terminals 21 and 22 are arranged on one end face of the container and spaced apart from each other. These terminals are formed of, for example, aluminum or aluminum alloy.

As shown in FIGS. 1 and 3 to 5, the housing 16 comprises a bottom wall 24 in the form of a rectangular plate, an open-bottomed cover body 26 in the form of a rectangular box, and a lid body 28 in the form of a rectangular plate. These members are formed of an insulating material such as a synthetic resin. The bottom wall 24 is formed with engagement grooves 25 as many as the secondary batteries 10, six in number in this case. Each engagement groove 25 has an elongated rectangular shape corresponding to the cross-sectional shape of the container 20 of each secondary battery 10 and extends transversely relative to the bottom wall 24. Further, the engagement grooves 25 are arranged at regular intervals along the length of the bottom wall 24.

Six engagement holes 27 as many as the secondary batteries 10 are formed in a ceiling wall 26a of the cover body 26. Each engagement hole 27 has an elongated rectangular shape corresponding to the cross-sectional shape of the container 20 of each secondary battery 10 and extends transversely relative to the ceiling wall 26a. The engagement holes 27 are arranged at regular intervals along the length of the ceiling wall 26a. When the cover body 26 is overlaid on the bottom wall 24, the engagement holes 27 are opposed individually to the engagement grooves 25 of the bottom wall 24. Partition ribs 30 are formed integrally on the inner surface of the ceiling wall 26a so as to be located individually in the adjacent engagement holes 27.

Each secondary battery 10 is contained in the housing 16 with the lower end portion of its container 20 fitted in each corresponding engagement groove 25 and with the upper end portion passed through each corresponding engagement hole 27 of the ceiling wall 26a. Thus, the six secondary batteries 10 are held in a row such that the respective principal surfaces of the containers 20 face one another with predetermined gaps between them. The one end face of each container 20 on which the positive and negative electrode terminals 21 and 22 are arranged is exposed into the engagement hole 27.

In the present embodiment, each two adjacent secondary batteries 10 are arranged in such a manner that their respective positive and negative electrode terminals 21 and 22 are located reversely to one another. In other words, the six batteries 10 are located so that the electrode terminals 21 and 22 are arranged alternately in two rows along their array.

The lid body 28 of the housing 16 comprises apertures 32 corresponding individually to the electrode terminals 21 and 22, and bosses 34 that support the battery management circuit board 14. The apertures 32 are arranged in two rows at regular intervals. Each aperture 32 has a rectangular shape greater than that of each electrode terminal of each secondary battery 10. The bosses 34 (e.g., three in number) protrude from the upper surface of the lid body 28 and are located individually on the longitudinally opposite end portions and central portion of the lid body 28.

The lid body 28 is fixed to the cover body 26 so as to overlie the ceiling wall 26a of the cover body 26, thereby covering one end face of each secondary battery 10. The positive and negative electrode terminals 21 and 22 of each secondary battery 10 are located in their corresponding apertures 32 of the lid body 28 and exposed upward through the apertures.

As shown in FIGS. 3 to 5, the secondary batteries 10 are connected in series by the bus-bars 18. Each bus-bar 18 is formed by, for example, bending a metal plate of aluminum or the like. Each bus-bar 18 comprises a pair of rectangular connecting portions 18a and a curved coupling portion 18b extending between the connecting portions 18a. Each connecting portion 18a is formed with a terminal aperture 18c with which the electrode terminal 21 or 22 of each secondary battery 10 engages. The connecting portions 18a serves as first connecting portions. Further, each bus-bar 18 comprises a connection terminal 36, which extends at right angles to a surface of each connecting portion 18a from the coupling portion 18b. The connection terminal 36 is formed of the same conductive material (aluminum in this case) as the bus-bar 18 so as to be integral with the bus-bar 18. The connection terminal 36 serves as a second connecting portion and its extended end portion is coated with a conductive film, such as copper that is easily wettable with solder.

One of the connecting portions 18a of each bus-bar 18 is connected to the electrode terminal 21 of each secondary battery 10, while the other connecting portion 18a is connected to the negative electrode terminal 22 of the adjacent secondary battery 10. Each connecting portion 18a is joined to its corresponding electrode terminal 21 or 22 by welding, e.g., laser welding, with the distal end portion of the electrode terminal fitted in the terminal aperture 18c. The laser welding may be replaced with electron beam welding or resistance welding. The six secondary batteries 10 are connected in series with one another by the five bus-bars 18. The respective connection terminals 36 of the bus-bars 18 extend upward in a direction substantially perpendicular to the lid body 28 of the housing 16.

Output terminals 40 are connected individually to the negative electrode terminal 22 of that one of the secondary batteries 10 which is located at one end of the array and the positive electrode terminal 21 of the battery 10 at the other end. Each output terminal 40 comprises a rectangular connecting portion 40a, a terminal aperture 40b in the connecting portion 40a, an output end portion 40c, and a connection terminal 42 extending perpendicularly upward from the connecting portion 40a. The output terminal 40 is integrally formed of a metal plate of aluminum or the like. Each connecting portion 40a is joined to its corresponding electrode terminal 21 or 22 by laser welding, with the distal end portion of the electrode terminal fitted in the terminal aperture 40b. The output end portion 40c extends onto the outside of the housing 26. The respective connection terminals 42 of the output terminals 40 extend upward in a direction substantially perpendicular to the lid body 28 of the housing 16.

The respective connection terminals 36 of the bus-bars 18 and the connection terminals 42 of the output terminals 40 are formed to be substantially flush with one another and arranged in two rows.

As shown in FIGS. 1, 3 and 5, the battery management circuit board 14 is formed having a rectangular shape substantially equal in size to the lid body 28 of the housing 16. A wiring pattern of copper foil or the like is formed on the circuit board 14, and control elements 44 are mounted on a substantially central part of the circuit board. These control elements 44 constitute a battery management unit 47, which measures and monitors the voltage, temperature, etc., of the secondary batteries 10.

The battery management circuit board 14 is formed with slit-shaped engagement holes 46 along its opposite side edges. These engagement holes 46 are arranged in two rows corresponding to the connection terminals 36 and 42 on the side of the battery pack body 12. Conductive layers 50 of copper foil or metal deposit are formed on the respective inner surfaces and peripheries of the engagement holes 46. The conductive layers 50 electrically conduct to the wiring pattern on the circuit board 14.

Resistors 52 are mounted on the battery management circuit board 14. The resistors 52 are formed to have resistance values of several to several hundreds of ohms and are connected between the battery management unit 47 and conductive layers 50. The resistors 52 serve to suppress overdischarge from the secondary batteries 10, thereby protecting the circuit board 14.

The battery management circuit board 14 is located above the battery pack body 12 and attached to the bosses 34 of the lid body 28 by screws 62. Thus, the circuit board 14 is supported on the bosses 34 and opposed to the lid body 28 with a gap therebetween.
The respective connection terminals 36 and 42 of each bus-bar 18 and each output terminal 40 are passed through their corresponding engagement holes 46 of the circuit board 14 and attached to the conductive layers 50 of the circuit board 14 by solder beads 54. Thus, the connection terminals 36 and 42 are connected mechanically and electrically to the circuit board 14 in a direct manner and further electrically connected to the battery management unit 47 through the resistors 52. The battery management circuit board 14 is supported by the bus-bars 18 and output terminals 40, as well as the bosses 34, and firmly supported on and connected to the battery pack body 12. Further, the circuit board 14 is electrically connected to the secondary batteries 10 through the bus-bars 18 including the connection terminals 36.

The battery management unit 47 of the battery management circuit board 14 measures and monitors the voltage and temperature of the secondary batteries 10, thereby preventing overcharge, overdischarge, etc., of the batteries.

According to the battery pack constructed in this manner, the bus-bars 18 that electrically connect the electrode terminals of the adjacent secondary batteries comprise the connection terminals 36 for detection, which are formed of the same material as the bus-bars and soldered directly to the battery management circuit board 14. Thus, the secondary batteries 10 are electrically connected to the circuit board 14 by the bus-bars 18. As compared with a conventional case where a plurality of lead wires are led around between secondary batteries and a circuit board, therefore, the battery pack body 12 and circuit board 14 can be connected more easily, and wrong connection can be prevented. Further, shorting of lead wires can be prevented to improve safety. Furthermore, the supporting structure for the circuit board 14 can be strengthened to improve the reliability of the secondary battery pack.

According to the arrangement described above, there may be obtained a secondary battery pack configured so that operations for connecting the secondary batteries and detection and control systems are simplified to prevent wrong connection and improve safety.

The following is a description of a secondary battery pack according to a second embodiment.

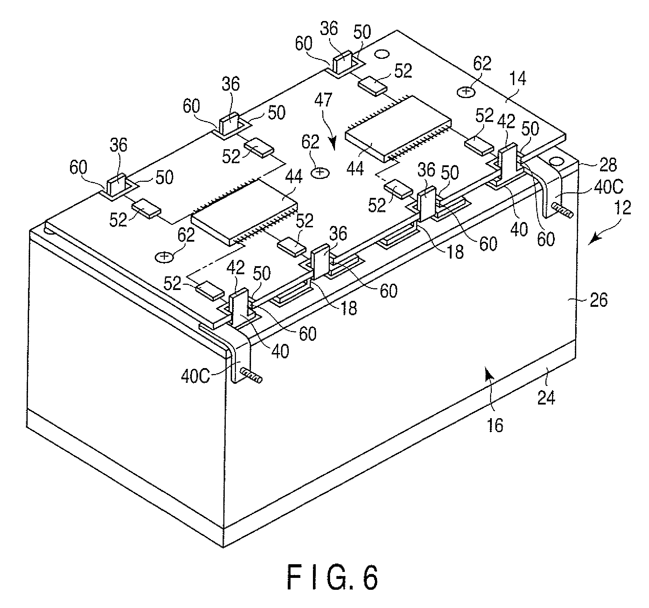

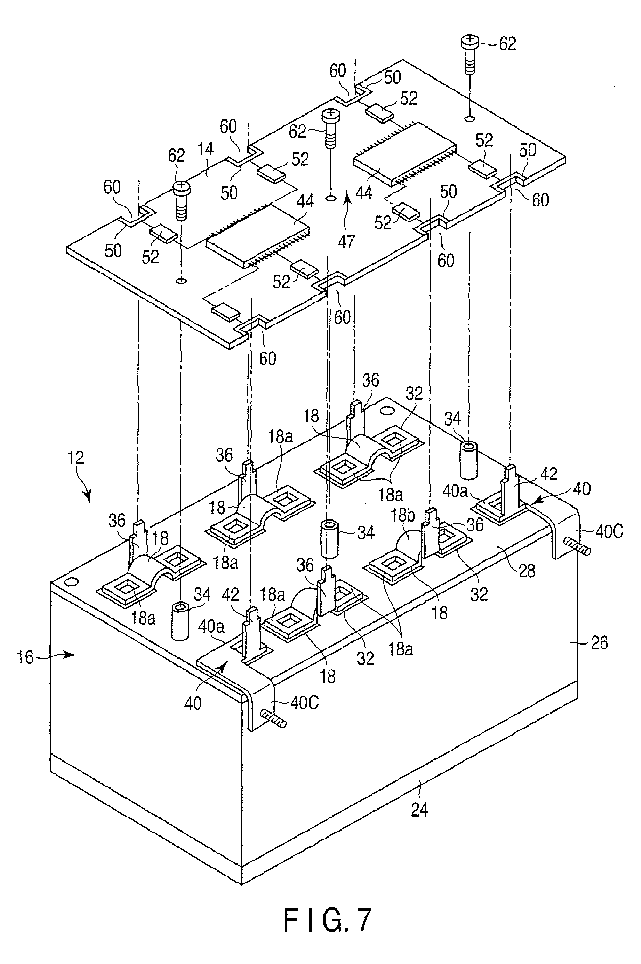

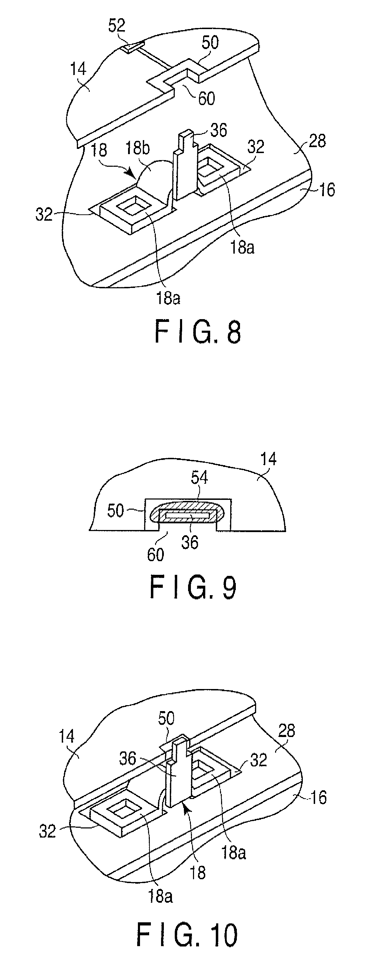

FIG. 6 is a perspective view showing the secondary battery pack according to the second embodiment, FIG. 7 is an exploded perspective view showing a body and circuit board of the battery pack, FIG. 8 is an enlarged perspective view showing a junction between the body and circuit board of the battery pack, and FIG. 9 is an enlarged plan view showing the circuit board and a connecting piece of the battery pack.

Like reference numbers refer to like portions of the first and second embodiments, and a detailed description of those portions is omitted. The following description is focused on difference portions.

According to the second embodiment, as shown in FIGS. 6 to 9, a battery management circuit board 14 comprises a plurality of notches (engagement recesses) 60 in its two opposite side edges. These notches 60 are arranged in two rows corresponding to connection terminals 36 and 42 on the side of a battery pack body 12. Each notch 60 is formed having a rectangular shape corresponding to the connection terminal 36 or 42 and a width and depth a little greater than the width and thickness, respectively, of the connection terminal. Conductive layers 50 of copper foil or metal deposit are formed on the respective inner surfaces and peripheries of the notches 60. The conductive layers 50 electrically conduct to a wiring pattern on the circuit board 14.

Resistors 52 are mounted on the battery management circuit board 14. The resistors 52 are formed to have resistance values of several to several hundreds of ohms and are connected between a battery management unit 47 and the conductive layers 50. The resistors 52 serve to suppress overdischarge from secondary batteries 10, thereby protecting the circuit board 14.

The battery management circuit board 14 is located above the battery pack body 12 and attached to bosses 34 of a lid body 28 by screws 62. Thus, the circuit board 14 is supported on the bosses 34 and opposed to the lid body 28 with a gap therebetween. The respective connection terminals 36 and 42 of each bus-bar 18 and each output terminal 40 are caused to engage with their corresponding notches 60 of the circuit board 14 and attached to the conductive layers 50 of the circuit board 14 by solder beads 54. Thus, the connection terminals 36 and 42 are connected mechanically and electrically to the circuit board 14 in a direct manner and further electrically connected to the battery management unit 47 through the resistors 52. The battery management circuit board 14 is supported by the bus-bars 18 and output terminals 40, as well as the bosses 34, and firmly supported on and connected to the battery pack body 12. Further, the circuit board 14 is electrically connected to the secondary batteries 10 through the bus-bars 18 including the connection terminals 36.

Other configurations of the battery pack body 12 and battery management circuit board 14 are the same as those of the first embodiment.

According to the battery pack of the second embodiment constructed in this manner, the bus-bars 18 that electrically connect the electrode terminals of the adjacent secondary batteries comprise the connection terminals 36 for detection, which are formed of the same material as the bus-bars and soldered directly to the battery management circuit board 14. Thus, the secondary batteries 10 are electrically connected to the circuit board 14 by the bus-bars 18. As compared with the conventional case where the lead wires are led around between the secondary batteries and circuit board, therefore, the battery pack body 12 and circuit board 14 can be connected more easily, and wrong connection can be prevented. Further, shorting of lead wires can be prevented to improve safety. The supporting structure for the circuit board 14 can be strengthened to improve the reliability of the secondary battery pack.

According to the second embodiment, moreover, the notches 60 are used as connecting portions of the battery management circuit board 14, so that the connection terminals of the bus-bars and output terminals can easily be aligned with the notches 60, and connecting operations can be further facilitated. In removing any of the secondary batteries 10 from the battery pack for the purpose of replacement or repair, furthermore, the connection terminals 36 and 42 and circuit board 14 can easily be disconnected, so that the maintenance performance is improved.

As shown in FIG. 10, for example, connecting portions for the connection terminals of the battery management circuit board 14 may be disposed on side edges of the circuit board 14. Specifically, the conductive layers 50 are formed on a plurality of parts of the side edges of the circuit board 14 and the surrounding parts, while the connection terminals 36 of the bus-bars 18 are connected directly to the side edges of the circuit board 14 through the conductive layers 50.

Even with this arrangement, the same function and effect as in the foregoing embodiments can be obtained, and the connection terminals can be connected more easily.

The number of secondary batteries used in the secondary battery pack is not limited to six and may be varied as required. The positive and negative electrode terminals of each secondary battery are not limited to the shape of a prism and may be of another shape, such as the shape of a circular column. The bus-bars need not always be provided with the terminal apertures. The connection terminal of each bus-bar 18 may be configured to extend from the connecting portion 18a in place of the coupling portion 18b. The shape and material of the bus-bars and the shape, material, and structure of the housing are not limited to the embodiments described herein and may be changed as required.

The bus-bar may have three or more first connecting portions configured to electrode terminals of three or more cells. The connecting terminal of the bus-bar may be formed of a material different from the material forming other part of the bus-bar.

## Claims

1. A secondary battery pack **characterized by** comprising:
a plurality of cells (20) each comprising a positive electrode terminal (21) and a negative electrode terminal (22) and arranged side by side;
a battery management circuit board (14) configured to monitor a voltage of the cells; and
a plurality of bus-bars (18) electrically connecting the electrode terminals (20, 21) of the adjacent cells (20), each of the bus-bars including first connecting portions (18a) connected to the electrode terminals and a second connecting portion (36) connected directly to the battery management circuit board.

2. The secondary battery pack according to claim 1, **characterized in that** the battery management circuit board (14) comprises a plurality of engagement holes (46), and conductive layers (50) formed around the engagement holes, individually, and the second connecting portions (36) are passed through the engagement holes and soldered to the conductive layers.

3. The secondary battery pack according to claim 1, **characterized in that** the battery management circuit board (14) comprises a plurality of notches (60) formed in side edges of the circuit board, and conductive layers (50) formed individually on peripheries of the notches including inner surfaces of the notches, and the second connecting portions (36) engage individually with the notches (60) of the battery management circuit board (14) and are soldered to the conductive layers (50).

4. The secondary battery pack according to claim 3, **characterized in that** the battery management circuit board (14) has a rectangular shape corresponding in size to the cells (20), and the notches (60) are formed in two opposite side edges of the battery management circuit board.

5. The secondary battery pack according to claim 3, **characterized in that** the battery management circuit board (14) includes two opposite side edges, and conductive layers (50) formed individually on the side edges, and the second connecting portions (36) are joined to the respective side edges of the circuit board through the conductive layers.

6. The secondary battery pack according to any one of claims 1 to 5, **characterized in that** each of the bus-bars (18) with the second connecting portions (36) is formed by bending a metal plate.

7. The secondary battery pack according to claim 6, **characterized in that** each of the bus-bars (18) comprises a pair of terminal apertures (18c) with which the electrode terminals (21, 22) of the cells (20) engage individually, and each of the second connecting portions (36) extends from that part of the bus-bar which is located between the terminal apertures.

8. The secondary battery pack according to claim 6, **characterized in that** each of the bus-bars (36) comprises two first connecting portions (18a), each comprising a terminal aperture (18c), and a coupling portion (18b) which connects the first connecting portions, and the second connecting portion (36) extends from the coupling portion.

9. The secondary battery pack according to claim 1, **characterized by** further comprising a housing (16) configured to contain the cells (20), and in that the housing (16) comprises a lid body (28) covering the cells and including a plurality of apertures (32) through which the positive and negative terminals (21, 22) are exposed, the bus-bars (18) are exposed on the lid body, and the battery management circuit board (14) is opposed to the lid body and the bus-bars.

10. The secondary battery pack according to claim 9, **characterized in that** the respective second connecting portions (36) of the bus-bars (18) are arranged along side edges of the battery management circuit board (14).

11. The secondary battery pack according to claim 9, **characterized in that** the respective connecting pieces (36) of the bus-bars (18) are arranged in two rows along two opposite side edges of the battery management circuit board (14).

12. The secondary battery pack according to claim 9, **characterized in that** the battery management circuit board (14) is supported on the lid body (28) and overlaid on the bus-bars.
